(19) Europäisches Patentamt
European Patent Office
Office européen des brevets

(11) **EP 3 480 614 A1**

(12) **EUROPEAN PATENT APPLICATION**

(43) Date of publication:
**08.05.2019  Bulletin 2019/19**

(51) Int Cl.:
*G01R 33/24* (2006.01)  *G01R 33/32* (2006.01)
*G01N 24/00* (2006.01)

(21) Application number: **17199705.9**

(22) Date of filing: **02.11.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Danmarks Tekniske Universitet 2800 Kgs. Lyngby (DK)**

(72) Inventors:
• **ANDERSEN, Ulrik Lund**
  **2830 Virum (DK)**
• **HUCK, Alexander**
  **3450 Allerød (DK)**
• **EL-ELLA, Haitham A. R.**
  **211 13 Malmö (SE)**
• **AHMADI, Sepehr**
  **2200 Copenhagen N (DK)**

(74) Representative: **Plougmann Vingtoft a/s Strandvejen 70 2900 Hellerup (DK)**

(54) **ABSORPTION DETECTED MAGNETIC RESONANCE (ADMR)**

(57) The invention relates to a magnetometer for measuring an external magnetic field (B_E) using absorption detected magnetic resonance (ADMR) in a solid state material (10), such as diamond, with an ensemble of paramagnetic defects, being optically active. In an optical cavity (20) surrounding the solid state material, a coupling structure (30) is performing radio frequency and/or microwave excitation ($\Omega$) of the paramagnetic defects in the ground state. A first optical detector (40) detects laser irradiation traversing the optical cavity (20) and not being absorbed in the solid state material. The laser irradiation is optically arranged for exciting ($\Gamma_P$) the ground state to an excited state in the solid state material (10), and the magnetometer subsequently applies a measure (S) indicative of the thereby absorbed laser irradiation obtained from the first optical detector (40) to measure the external magnetic field (B_E). The invention is advantageous for both miniaturization and having improved sensitivity down to pico-Tesla/(Hz)^½ .

(b)

Fig. 1B

**Description**

FIELD OF THE INVENTION

The present invention relates to a magnetometer for measuring a magnetic field using optically active defects in a solid state material, such as a diamond crystal with nitrogen-vacancy (NV) centers or defects, and a corresponding method for measuring such magnetic fields.

BACKGROUND OF THE INVENTION

Conventional magnetometer products consist of MEMS-based microchips with sensitivities scaling down towards the 10 nano-Tesla/Hz^(1/2) level, which limits their applicability to sensing large fields such as those stemming from geomagnetic processes, or electro/magneto-electronics. Their application is also limited to particular processes at a time as they are only capably of sensing within narrow frequency bandwidths, in environments that will not degrade their electronic functionality.

Apart from diamond-based magnetometers, high sensitivity magnetometers (with pico- to femto- Tesla sensitivities) are only achieved with atomic vapor cells and superconducting interference devices. Atomic vapor may be dangerous, and while it is enclosed in a glass cell, it may only find limited use in a clinical setting due to safety reasons. In addition, superconducting devices require cryogenic temperatures making them extremely expensive and limited in their applicability.

Many magnetometer schemes using nitrogen-vacancy (NV) centers in diamonds are based on recording the change in the detected fluorescence level upon a shift of the electron spin resonance frequency due to an external magnetic field. The fluorescence contribution of an ensemble of NV centers to the signal increases the optically detected magnetic resonance (ODMR) amplitude and hence boosts the sensitivity by $\sqrt{N}$, where N is the number of spins. However, the high refractive index of diamond (approximately 2.4) together with the near uniform emission of NV centers trap most of the generated fluorescence due to total internal reflection. This limits the collection efficiency and, thus, the smallest detectable magnetic field change. To increase the fluorescence collection from a diamond, several techniques have recently been demonstrated such as fabricating a solid immersion lens, side-collection detection, employing a silver mirror, using a dielectric optical antenna, emission into fabricated nanopillar waveguides and employing a parabolic lens.

Alternatively, magnetic fields can also be sensed by observing the change in the shelving-state infrared absorption in ODMR, cf. K. Jensen, et al. in Physical Review Letters 112, 160802 (2014), which however requires at least two lasers, one laser for pumping from the ground state and another laser for probing an excited state, and subsequently measure the transmitted laser power. Hence, for miniaturization of such a magnetometer, the two lasers present an inherent barrier for any further miniaturization in addition to the fundamental problems associated with applying fluorescence for ODMR. Having two different lasers also requires generally two different kind of coatings for the diamond sample, making the device more complex.

Hence, an improved optical-based magnetometer would be advantageous, and in particular a more efficient and/or reliable magnetometer, especially for further miniaturization of an improved sensitivity magnetometer, would be advantageous.

OBJECT OF THE INVENTION

It is a further object of the present invention to provide an alternative to the prior art.

In particular, it may be seen as an object of the present invention to provide a more efficient magnetometer that solves the above mentioned problems of the prior art with improved sensitivity and/or capability of miniaturisation.

SUMMARY OF THE INVENTION

Thus, the above described object and several other objects are intended to be obtained in a first aspect of the invention by providing a magnetometer for measuring an unknown external magnetic field (B_E) using absorption detected magnetic resonance (ADMR), comprising:

a) a solid state material comprising an ensemble of paramagnetic defects, the paramagnetic defects being optically active,

b) an optical cavity surrounding the solid state material, the optical cavity being optically excitable by laser irradiation from a laser arranged therefore,

c) a coupling structure being arranged for electromagnetic coupling to said solid state material, the coupling structure being arranged for substantially homogenous radio frequency and/or microwave excitation ($\Omega$) of the paramagnetic defects in the ground state (|1>,|2>), and

d) a first optical detector arranged for detecting laser irradiation traversing the optical cavity and not being absorbed in the solid state material,
wherein the laser irradiation is optically arranged for exciting the ground state (|1>,|2>) to an excited state (|3>,|4>) in the solid state material, and the magnetometer subsequently applies a measure indicative of the thereby absorbed laser irradiation obtained from the said first optical detector to measure the external magnetic field (B_E).

The invention is particularly, but not exclusively, advantageous for obtaining a magnetometer, which has enhanced capability of both miniaturization and having improved sensitivity. A specific advantage as compared to for example Jensen et al. mentioned above is that the present invention can be implemented with only one irradiation laser for excitation of the paramagnetic defects, whereas the Jensen et al. setup requires two laser sources, one for pumping the paramagnetic defects and one for probing. Furthermore, the use of fluorescence and its challenges associated with collection is completely avoided due to the more direct use of the said measure indicative of the absorbed laser irradiation instead.

Therefore, the principle of the present invention is described in the context of this patent application as Absorption Detected Magnetic Resonance (abbreviated 'ADMR'), in contrast to other measurement setups, like Jensen et al. and others, often called Optically Detected Magnetic Resonance i.e. abbreviated 'ODMR'. As it will be demonstrated below, the present invention especially facilitates sub-pT/√Hz sensitivities to be achieved, and possibly even better sensitivities.

The magnetometer of the present invention may therefore have direct applications in fields ranging from sub-surface geophysical exploration, to biomedical sensing and imaging of magnetically active processes/specimens (both ex- and in-situ) due to its ease of handling, non-toxicity, bio-compatibility and low optical power consumption compared to competing technologies available.

In the context of the present invention, it is to be understood that 'measuring an unknown external magnetic field (B_E)' may include measuring a direction and/or a magnitude of the magnetic field desirable to measure. In particular, it is also be understood that the magnetometer according to the present invention may measure a direction and/or a magnitude of the magnetic field along a certain axis, e.g. a quantization axis of the paramagnetic defects, thereby measuring effectively a projection of the external magnetic field along said axis. The skilled person in magnetometers, particular optically based magnetometers, will readily understand that if any additional projection(s) of the external magnetic field is desirable to measure, it is possible to change crystal axis of the defect which changes the quantization axis, e.g. by changing the direction of an otherwise constant, directional magnetic field giving a Zeeman splitting of the paramagnetic defects. Thus, making three measurements along different crystal axes may yield the total magnetic field vector, either three measurements consequently in time using one magnetometer, or three combined measurements using three parallel magnetometers at the same time, or any combinations of these configurations for measuring direction and magnitude of the external magnetic field. If time development of the external magnetic field is of importance, several magnetometers according to the present invention, each having different axis of quantization, would of course be feasible. For further variants and details for measuring the direction and magnitude of an external magnetic field (B_E) using optically based magnetometers from NV diamond having four crystallographic axis, the skilled reader is referred to International patent application

WO 2016/126436 (to Lockheed Martin Corp.), which is hereby incorporated by reference in its entirety.

It may be noted that the disclosure of WO 2012/174019 also applies absorption of laser irradiation in NV of a diamond for magnetometer purposes, but does not apply, teach or suggest, inter alia the implementation of an optical cavity, hence the achievable sensitivity is not within range of the present invention. Therefore, the use of impedance matching is not possible with WO 2012/174019 making this reference not suited for improved sensitivity measurements, i.e. at the sub-pT/√Hz level and better.

In the context of the present invention, an 'optical cavity' is understood to comprise at least two reflecting mirrors (or similar optical entities) mutually arranged for being capable of reflecting light within the optical civility for creating a standing wave of light. Optical cavities are also known as optical resonators or resonating cavities as the skilled person in optics will readily appreciate.

In the context of the present invention, the 'coupling structure being arranged for electromagnetic coupling to said solid state material' may be understood to be capable of excitation of the paramagnetic defects in the radio frequency or microwave range of electromagnetic radiation. Thus, an antenna or a suitable nearby waveguide may be examples of said coupling structure in the context of the present invention. Radio frequency (RF) radiation may be broadly understood to be electromagnetic radiation approximately in the 3 kHz to 300 GHz range, and microwave radiation being typically in the approximate range of 300 MHz to 300 GHz, particularly microwave radiation of at least 1 GHz, 2 GHz, or 3 GHz may be applied in the context of the present invention. The coupling structure is further arranged for homogenous excitation in said probe volume in the solid state material, e.g. in the diamond crystal, more particular the excitation varies maximum 5%, maximum preferably 2.5%, most preferably maximum 1% across the probe volume in the solid state material.

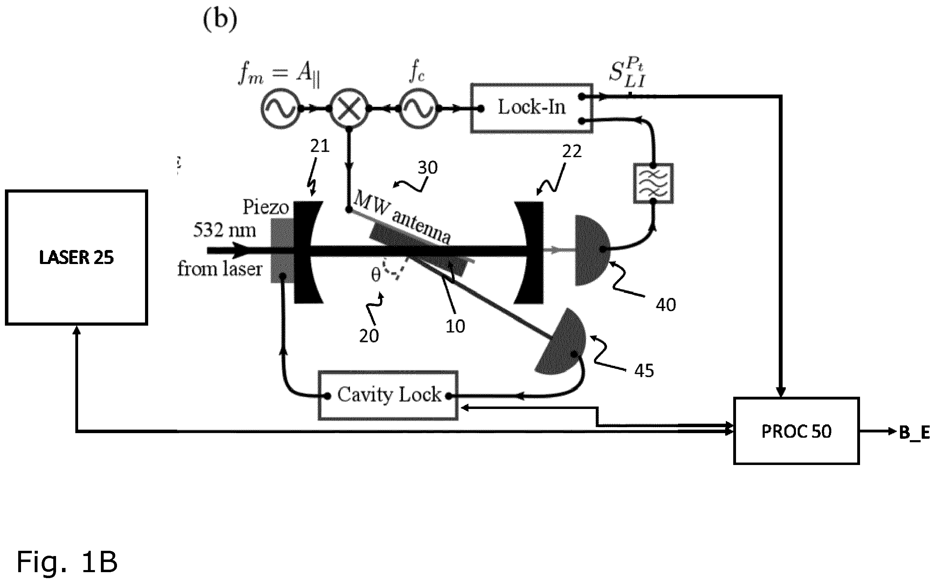

In one embodiment, the first optical detector may be positioned so as to detect laser irradiation being reflected from the same side of optical cavity as the laser irradiation enters the optical cavity, which may be advantageous for miniturisation and/or improved sensitivity. This can be realized for example with an optical circulator splitting input and output from the optical cavity. It should be mentioned that the first optical detector may alternatively be positioned on the opposite side of optical cavity as the laser irradiation enters the optical cavity i.e. in a transmission configuration, as for example in Figure 1B below.

In another embodiment, the optical cavity surrounding the solid state material may comprise two mirrors, e.g. opposite one another. Additionally or alternatively, a second optical detector may be optically connected to the optical cavity and arranged for providing a signal output to a feedback mechanism, e.g. a 'cavity lock', for adjusting the said optical cavity and/or the irradiation laser, preferably by actuating one, or more, of the two mirrors, and/or by changing one or more optical properties of one, or more, of the two mirrors.

In an alternative embodiment, the first optical detector may be optically connected to the optical cavity and arranged for providing a signal output to a feedback mechanism, e.g. a 'cavity lock', for adjusting the said optical cavity and/or the irradiation laser.

In another embodiment, the optical cavity surrounding the solid state material may comprise two mirrors, and the two mirrors may in combination define an optical path for said laser irradiation traversing the optical cavity through said solid state material, said optical path preferably having a substantially straight Gaussian beam shape within the solid state material. This is particularly advantageous for further miniaturization by allowing the beam to traverse the sample multiple times, i.e. increasing the optical depth in a compact manner.

In another embodiment, the optical cavity surrounding the solid state material may have a maximum cumulative round trip loss product in the cavity, $\rho$, of 20, 10, or 5 %. Alternatively or additionally, the irradiation laser may be configured to be substantially resonant with the optical cavity.

Furthermore, the optical cavity may impedance matched with the irradiation laser, preferably substantially impedance matched, preferably so that said impedance matching is performed by levelling an incoupling mirror as being substantially equal to the cumulative round trip loss product in the cavity, more preferably by configuring the magnetometer according to the approximate relation

$$P_{cav} = P_{laser}\, T_1\, /(1 - \rho)^2,$$

where $T_1$ is the transmission of an incoupling mirror, $\rho$ is the cumulative round trip loss product in the cavity, $P_{laser}$ is the power of the irradiation laser, and $P_{cav}$ is the intra-cavity power, and it is understood that impedance matching is obtained when $\rho$ approaches $T_1$. Preferably, wherein the irradiation laser may be configured for being emitted as a continuous wave when measuring the external magnetic field (B_E).

In an advantageous embodiment the coupling structure may be operated at a working frequency (f_c*) where the absolute value of a derivative, with respect to the working frequency, of said measure (S) indicative of the absorbed laser irradiation is maximized to optimize sensitivity and/or measurement stability. Preferably, the magnetometer may be further operated at a specific combination of laser power input (P_in) of the laser irradiation, and a working frequency (f_c*) of the coupling structure, where a magnetic field sensitivity is optimized.

In some embodiments, optical means and measures may be applied to remove or reduce high-order modes from said laser irradiation before entering the optical cavity so as to reduce a signal to noise ratio (S/N) in said measure (S) indicative of the absorbed laser irradiation to further improve sensitivity.

In an advantageous embodiment, the magnetometer may be capable of measuring the said external magnetic field (B_E) using only a single excitation energy ($\Gamma_P$), preferably emitted by a single irradiation laser, which particularly enables miniaturization.

In some embodiments, the solid state material may be a single crystal diamond, and the paramagnetic defects are nitrogen vacancy centers (NV), preferably with impurities levels of NV being maximum 10 ppm, preferably maximum 1 ppm, more preferably maximum 0.5 ppm. These levels are at a level commercially available at a reasonable level, which facilitates that the present invention is not dependent on high-level NV diamond, thus paving the way for various commercial applications of diamond based ADMR. In some embodiments, lower impurity levels of maximum 100 ppb, or maximum 500 ppb may be applied.

Alternatively, SiC, sapphire, etc. may be applied in the context of the present invention, i.e. sample which comprises an ensemble of paramagnetic defects, the paramagnetic defects being optically active.

In beneficial embodiments, the magnetometer - when measuring an external magnetic field (B_E) - may be arranged for having a sensitivity of maximum 300 pT/(Hz)^½, preferably a sensitivity of maximum 100 pT/(Hz)^½, more preferably a sensitivity of maximum 50 pT/(Hz)^½, or even more preferably a sensitivity of maximum 1 pT/(Hz)^½, which is highly beneficial for various applications where improved sensitivity magnetometry has hitherto not been possible. It is in fact contemplated that further optimisation of the present invention may result in reaching a sensitivity in the femto-Tesla/(Hz) ^½ region.

In a second aspect, the present invention relates to a method for measuring an external magnetic field (B_E) using absorption detected magnetic resonance (ADMR), the method comprising:

- providing a solid state material comprising an ensemble of paramagnetic defects, the paramagnetic defects being optically active,

- providing an optical cavity surrounding the solid state material, the optical cavity being optically excitable ($\Gamma_P$) by laser irradiation from a laser arranged therefore,

- providing a coupling structure being arranged for electromagnetic coupling to said solid state material, the coupling structure being arranged for substantially homogenous radio frequency and/or microwave excitation ($\Omega$) of the paramagnetic defects in the ground state ($|1>,|2>$), and

- providing a first optical detector arranged for detecting laser irradiation traversing the optical cavity and not being absorbed in the solid state material,

wherein the laser irradiation is optically exciting ($\Gamma_P$) the ground state ($|1>,|2>$) to an excited state ($|3>,|4>$) in the solid state material, and subsequently applying a measure (S) indicative of the thereby absorbed laser irradiation obtained from the said first optical detector to measure the external magnetic field (B_E).

The individual aspects of the present invention may each be combined with any of the other aspects. These and other aspects of the invention will be apparent from the following description with reference to the described embodiments.

BRIEF DESCRIPTION OF THE FIGURES

An embodiment of a magnetometer using ADMR according to the present invention will now be described in more detail with regard to the accompanying figures. The figures show one way of implementing the present invention and is not to be construed as being limiting to other possible embodiments falling within the scope of the attached claim set.

Figure 1A is an energy diagram of the NV defects in diamond,

Figure 1B is a schematic drawing of the experimental setup of a magnetometer using ADMR according to the present invention,

Figure 2 shows characteristics of the frequency-modulated ADMR spectrum used in an embodiment of a magnetometer using ADMR according to the present invention,

Figure 3 shows simulated and measured frequency-modulated ADMR in an embodiment of a magnetometer using ADMR according to the present invention,

Figure 4 shows a) measurement of the magnetic noise spectral density in an embodiment of the present invention, and b) response of such a magnetometer of 10 mHz applied square-wave magnetic field,

Figure 5 shows simulated plots of the shot-noise-limited sensitivity in embodiment of a magnetometer using ADMR according to the present invention, and

Figure 6 is a schematic system-chart representing an out-line of a method according to the invention.

DETAILED DESCRIPTION OF AN EMBODIMENT

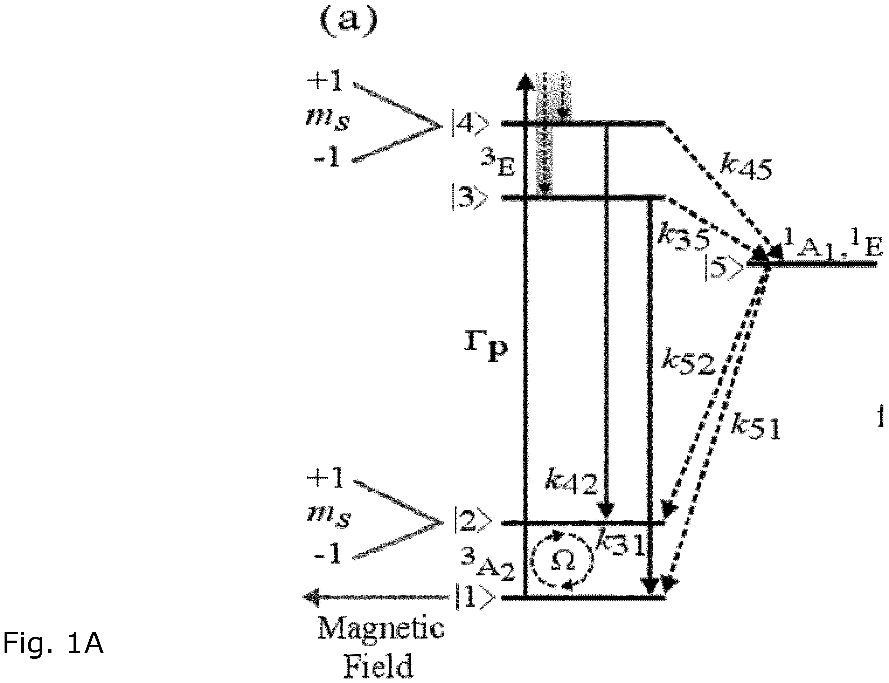

Figure 1A is an energy diagram of the NV defects in diamond with the electronic level structure of the NV defect is summarized. It consists of a $^3A_2$ spin-triplet ground state, a $^3E$ spin-triplet excited state, and a $^1A1 \leftrightarrow 1E$ shelving state. Pumping with a 532 nm laser results in an above-band excitation, which decays on a picosecond timescale to the $^3E$ excited states by non-radiative transitions, though many other laser irradiation wavelengths are of course useful in context of the present invention as the skilled person in optics and magnetometers will readily understand. The decay between two states is shown by $k_{ab}$, i.e. $k_{45}$ indicates the decay constant between state 4 and 5, and $\Omega$ corresponds to the Rabi frequency of the MW drive used to mix the ground level states 1> and 2>.

Moreover, there exists a non-radiative decay path through the shelving state which is more probable for $m_s = \pm 1$ of the excited state |4>. The zero-field splitting of the ground state levels |1> and |2> is ~ 2.87 GHz at room temperature, making the transition between these levels accessible using microwave (MW) fields. The presence of a local magnetic field lifts the degeneracy of $m_s = \pm 1$ with a splitting proportional to $2\gamma_e B_{NV}$, where $\gamma_e$ = 2.8 GHz/T is the gyromagnetic ratio of the electron spin and $B_{NV}$ corresponds to the magnetic field projection along the NV symmetry axis. A change in the external magnetic field hence results in a detectable shift in the electron spin resonance frequency of the ADMR spectrum. The continuous-wave sensitivity of the spin resonances to small changes of an external magnetic field is proportional to max$[d/d_w S]^{-1}$, where $d/d_w$ is the derivative with respect to the MW frequency $\omega/2\pi$ and $S$ denotes the ADMR signal. Using a cavity 20, a change in S can be detected in the measurement of either the transmitted, or reflected, light from the cavity as will be explained below.

Figure 1B is a schematic drawing of the experimental setup of a magnetometer 100 using ADMR according to the present invention. Thus, a magnetometer 100 comprises a solid state material 10, such as diamond, comprising an ensemble of paramagnetic defects, the paramagnetic defects being optically active. An optical cavity 20 is surrounding the solid state material, the optical cavity being optically excitable, as indicated by $\Gamma_P$ in Figure 1B, by laser irradiation from a laser 25 arranged therefore. Preferably, the laser 25 is arranged for being operated in continuous mode (CW), but pulsed mode may also be applied.

Moreover, a coupling structure 30 is arranged for electromagnetic coupling to said solid state material 10, the coupling structure being arranged for substantially homogenous radio frequency and/or microwave excitation, e.g. Rabi oscillations $\Omega$ cf. Figure 1A, of the paramagnetic defects in the ground state, |1> and |2>.

A first optical detector 40 is arranged for detecting laser irradiation traversing the optical cavity 20 and not being absorbed in the solid state material. The optical cavity 20 is thus surrounding the solid state material and comprises two mirrors 21 and 22, and an additional second optical detector 45 is optically connected to the optical cavity and arranged for providing a signal output to a feedback mechanism, as indicated with the box 'Cavity Lock', for adjusting the said optical cavity 20 and/or the irradiation laser 25, preferably by actuating one, or more, of the two mirrors, e.g. by 'Piezo' element on the rear side of mirror 21 as shown, and/or by changing one or more optical properties of one, or more, of the two mirrors. In some embodiments, it may also be possible to actuate the solid state material, e.g. by rotation as indicated by the angle θ, so as to fine tune the optical cavity 20.

The optical cavity with the two mirrors in combination defines an optical path for said laser irradiation traversing the optical cavity 20 through said solid state material 10, the optical path preferably having a substantially straight Gaussian beam shape, preferably a cylindrical shape, within and through the solid state material 10.

Particularly, the laser irradiation is optically arranged for exciting the ground state, |1> and |2>, to an excited state, |3> and |4>, in the solid state material 10, and the magnetometer then subsequently applies a measure S indicative of the thereby absorbed laser irradiation obtained from the said first optical detector 40 to measure the external magnetic field B_E as it will be explained and documented in more detail below.

The overall process is controlled by one (or more) processor 50 operably connected to the first 40 and second 45 detectors, the laser 25, the coupling structure 30, e.g. the MW antenna as shown here, and other components as shown schematically in Figure 1B. Particularly, the processor 50 can receive a measure S indicative of the absorbed laser irradiation and convert it to a measured external magnetic field B_E.

Specifically, the optical cavity has two concave mirrors 21 and 22 with a 10 cm radius of curvature set in a confocal configuration, resulting in a minimum beam waist of 92 μm with a Rayleigh length of ~ 50 mm. The mirrors have the measured reflectivities of R1 = 94.8% $\pm$ 0.1% and R2 = 99.8% $\pm$ 0.1% at the pump wavelength of 532 nm. With the diamond tilted at it's Brewster angle ($\theta \sim 67°$), the round-trip beam path in the diamond is $l$ = 2 x 1.3 mm and the estimated excitation volume is ~ 3.5 x $10^{-2}$ mm$^3$, accounting for the standing wave and the transverse beam profile. The finesse of a cavity is defined by $F = n \sqrt{\rho}/(1 - \rho)$, where $\rho = (R1R2e^{-\alpha})^{\frac{1}{2}}$ corresponds to the cumulative round-trip loss product and is the propagation loss coefficient. In the absence of the diamond, the finesse solely depends on the product of the mirror reflectivities $R1R2$ and is calculated as $F$ = 113.4 $\pm$ 4.4, which is confirmed by the measured finesse of $F$ = 114.

Incorporating the diamond into the cavity reduced the finesse to $F$ = 45, which indicates that all the effective loss in the loaded cavity can be attributable solely to losses occurring through the diamond. The corresponding cumulative round-trip loss of the loaded cavity shows that the cavity is slightly under-coupled. The propagation loss can be decomposed to $\alpha = \alpha_{abs} l + \alpha_r$, in which $\alpha_{abs}$ is the absorption loss coefficient and $\alpha_r$ is attributed to all other loss channels such as surface-based absorption, scattering losses, and birefringence losses. The total fraction of reflected light from the diamond to intra-cavity power was measured as ~ 0.006, of which approximately 80% was s-polarized light. This translates to an absorption loss coefficient of $\alpha_{abs}$ ~ 0.0301 mm$^{-1}$, taking $\alpha_r$ ~ 0.006. With an independent measurement using a confocal microscope, we determined the NV-concentration, [NV-], to be ~ 2.9 x $10^{10}$ mm$^{-3}$ (~ 0.16 ppb) corre-

sponding to ~ $10^9$ NV- within the excitation volume. Considering the absorption cross section of a single $^{14}$NV- at 532 nm ($\sigma_{NV}$ = 3.1 x $10^{-15}$ mm$^2$), a NV related absorption loss coefficient of $\alpha^{NV}_{abs}$ ~ 9 x $10^{-5}$ mm$^{-1}$ is obtained. Hence, most of the propagation loss is attributed to non-NV loss channels in our diamond sample. Using the NV absorption loss coefficient, we estimate the ratio between the excitation rate and the intra-cavity power $\varepsilon$ = Γp/$P$cav ~ 30 kHz/W, where the intra-cavity and incident powers are linked through $P_{cav}$ = $P_{in}$(1 - R1)/|1 - ($R1R2e^{-\alpha}$)$^{\frac{1}{2}}$|$^2$.

ADMR measurements were obtained by recording the transmitted pump-light through the diamond loaded cavity while sweeping the MW drive frequency across the spin resonance. In order to remove low frequency technical noise, we applied lock-in detection with a frequency modulated MW drive as illustrated in Fig. 1(b), directly yielding $S^{Pt}_{LI}$ at the output, where Pt indicates the transmitted power through the cavity 20 and $LI$ refers to lock-in. In these measurements, a magnetic field was aligned to the NV symmetry axis of one of the four crystallographic orientations.

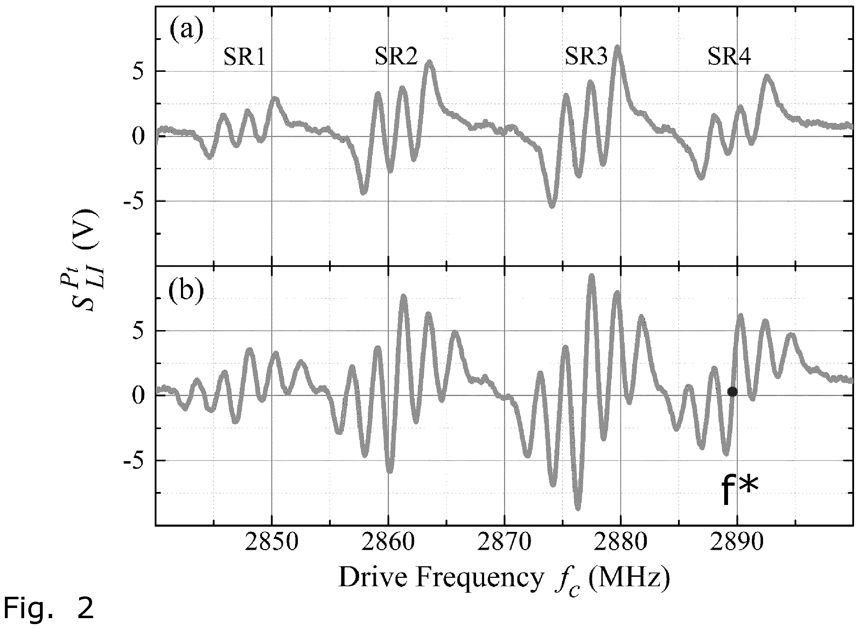

Figure 2 shows characteristics of the frequency-modulated ADMR spectrum used in an embodiment of a magnetometer using ADMR according to the present invention. Briefly, the measured frequency-modulated ADMR spectrum using (a, upper graph) single-frequency excitation and (b, lower graph) three-frequency excitation. SR1 and SR4 correspond to the electron spin resonances of single crystallographic orientation of NVs, while SR2 and SR3 correspond to the electron spin resonances of the other three crystallographic orientations. The black dot in (b) indicates the point that is most sensitive to small changes in the magnetic field. Thus, the coupling structure 30 is preferably operated at a working frequency f_c* around 2890 MHz in this example, where the absolute value of a derivative, with respect to the working frequency, of the measure S indicative of the absorbed laser irradiation is maximized.

The three-peak feature of the ADMR spectrum in Fig. 2(a) is a consequence of the hyperfine interaction between the NV electron spin and the defects intrinsic $^{14}$N nuclear spin with a coupling constant of $A_{\parallel}$ = 2.16 MHz. To enhance max[d/dw ($S^{Pt}$ LI)], all three hyperfine transitions were simultaneously excited by mixing the modulation frequency $f_c$ with a $f_m$ = $A_{\parallel}$ signal, as shown by the measured spectrum in Fig. 2B. An ADMR spectrum $S_{LI}$ may be obtained either by recording the pump beam reflected from the cavity, $S^{Pr}_{LI}$, or transmitted through the cavity, $S^{Pt}_{LI}$, as a function of the applied MW frequency, and may be modelled using a set of optical Bloch equations considering the five electronic levels and the transitions summarized in Fig. 1A. In figure 1B, the magnetometer 100 is shown in a transmission configuration where the laser irradiation is emitted from the optical cavity 20 on the right side, i.e. on the opposite side relative to incoming 532 nm laser irradiation from the laser 25 shown on the left. The steady-state level populations $\rho^{ss}$ are then obtained as a function of Rabi frequency $\Omega$, optical excitation rate $\Gamma_p$, and MW detuning $\Delta$ from the spin $m_s$ = 0 $\leftrightarrow$ $m_s$ = $\pm$1 transition.

The cavity reflection or transmission itself is a function of loss inside the optical cavity 20 which is dominated by the absorption in diamond 10, while the NV absorption in diamond depends on the NV ensemble ground state spin population. Applying a resonant MW field ($\Delta$= 0) increases the population in the shelving state |5> which possesses a longer lifetime (> 150 ns), and hence, a lower average population remains in the ground states |1> and |2> to absorb the pump photons. Ultimately, the resonant MW field decreases the optical loss inside the cavity 20, which can be monitored through the light transmitted, cf. Fig. 1B, or alternatively reflected, from the cavity. The steady-state population of the optical ground state can be written as:

$$\rho^{ss}_g(\Omega, \Gamma_p, \Delta) = \rho^{ss}_{11} + \rho^{ss}_{22}, \qquad (1)$$

where $\rho^{ss}_{11}$ and $\rho^{ss}_{22}$ are the steady-state population of |1> and |2>, respectively.

The fractional change in the ground state population upon the application of a MW field can be defined in terms of:

$$\Delta\rho^{ss}_g = \frac{\rho^{ss}_g(\Omega, \Gamma_p, \Delta)}{\rho^{ss}_g(0, \Gamma_p, \Delta)}. \qquad (2)$$

As the absorption of a NV ensemble directly depends on $\rho^{ss}_g$, a change in the total absorption loss coefficient $\Delta\alpha_{abs}$ is assumed to be equivalent to an alteration in the ground state population $\Delta\alpha_{abs} \equiv \Delta\rho^{ss}_g$. Therefore, a change in the propagation loss as a function of [NV-] can be described as:

$$\alpha(\Omega, \Gamma_p, \Delta, [NV^-]) = \alpha^0_{abs} + [NV^-]\sigma_{NV}l\Delta\rho^{ss}_g + \alpha_r, \quad (3)$$

where $\alpha^0_{abs}$ is the loss coefficient attributed to non-NV absorption. As pump absorption in our sample is dominated by non-NV related processes, the absorption-based contrast $C_{ADMR}$ related to the fraction $\alpha^{NV}_{abs}/\alpha$ is on the order of $10^{-6}$ when monitoring the absorption through the cavity transmission, due to the cavity resonance bandwidth and impedance matching conditions. The steady-state cavity outputs as a function of MW detuning is then reformulated in terms of transmitted and reflected powers:

$$\frac{P_t}{P_{in}} = \frac{T_1 T_2 e^{-\alpha(\Omega,\Gamma_p,\Delta,[NV^-])}}{|1 - \sqrt{R_1 R_2} e^{-\alpha(\Omega,\Gamma_p,\Delta,[NV^-])}|^2}, \qquad (4)$$

$$\frac{P_r}{P_{in}} = \frac{(R_1 - \sqrt{R_1 R_2} e^{-\alpha(\Omega,\Gamma_p,\Delta,[NV^-])})^2}{R_1|1 - \sqrt{R_1 R_2} e^{-\alpha(\Omega,\Gamma_p,\Delta,[NV^-])}|^2}, \qquad (5)$$

where $P_{in}$ is the laser input power to the cavity, T1 and T2 are the transmissions of the first and the second mirror, respectively, and we assume Ri + Ti= 1. For the sake of simplicity, the intra-cavity excitation rate ($\Gamma_P = \varepsilon P_{cav}$) is calculated in terms of the input power and the propagation loss when no MW field is applied ($\Omega = 0$, $\Delta\rho^{ss}_g = 1$). The lock-in signal $S^{Pi}_{LI}$ can be described as a function of detuning between the carrier frequency $f_c$ and the resonance frequency $f_0$ ($\Delta = f_c - f0$), and the modulation depth $\delta$ through:

$$S^{P_i}_{LI}(\Delta) = \frac{GV_0}{2} \sum_{m_x} \sum_{m_l} [P_i(\Delta + \delta + (m_l + m_x)A_{\parallel})$$
$$- P_i(\Delta - \delta + (m_l + m_x)A_{\parallel})], \qquad (6)$$

where G is the lock-in gain factor, $V_0$ is the off-resonant detected voltage, and $P_i$ is either the reflected, or transmitted, cavity power. The expression is summed over the 14N nuclear spin quantum number ml = {-1,0,1}, and the three frequencies $m_x$ separated by $A_{\parallel}$ in order to account for the simultaneous drive of all three hyperfine transitions.

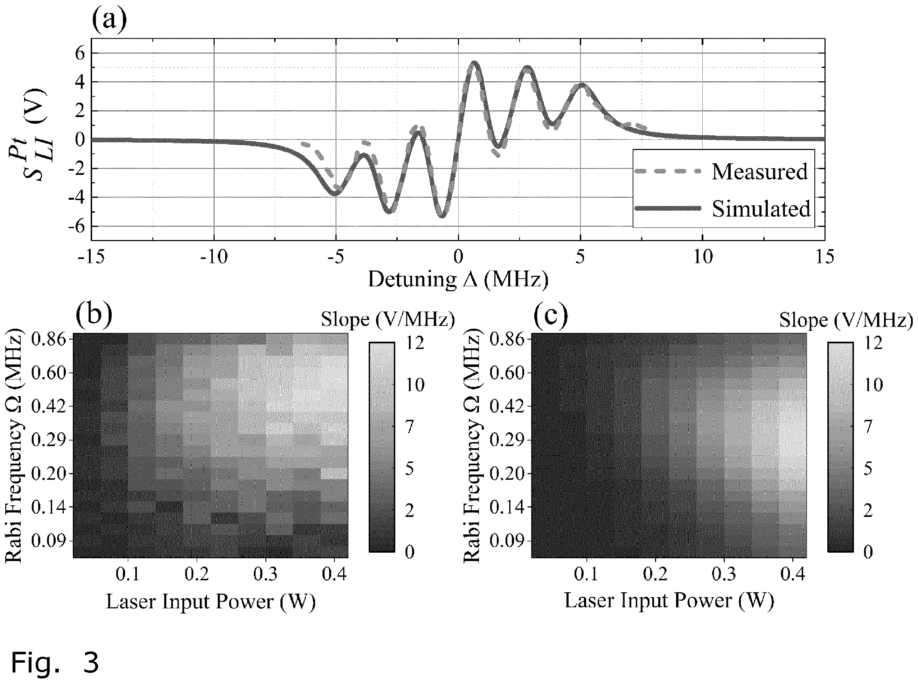

Figure 3 shows simulated and measured frequency-modulated ADMR in an embodiment of a magnetometer using ADMR according to the present invention. Thus, using Eq. (6), $S^{Pt}_{LI}$ is plotted as a solid line in Fig. 3 (a), taking $P_{in} = 0.4$ W, $\Omega = 0.3$ MHz, a pure dephasing rate of $\gamma_2^* = 1/3$ MHz, a longitudinal relaxation rate of $\gamma_1 = 1$ kHz, and using level decay rates $k_{ab}$ extracted from a reference. Plotted in Figure 3 (a) is the measured ADMR spectrum as a dashed line. The ADMR spectrum was recorded with the same $P_{in}$ and $\Omega$ as the simulated spectrum. The match between the simulated and measured traces is very good, with just a small mismatch due to the uncertainty in the estimation of the simulated parameters $\varepsilon$, $\gamma_2^*$, and $\alpha^0_{abs}$.

To optimize the magnetic field sensitivity, the dependence of d/d$_w$($S^{Pt}_{LI}$) of three-frequency excitation spectra on the polarizing and driving rates $P_{in}$ and $\Omega$ at $\Delta = 0$ were measured. The results of these measurements are presented in Fig. 3(b). The maximum slope is achieved at $P_{in} = 0.4$ W and 0.3 MHz, where the optical excitation rate by virtue of the cavity enhancement overcomes the MW power-induced dephasing rate, allowing for a light-narrowing regime to be reached. The simulated slopes are presented in Fig. 3(c) and obtained using the same parameters as in Fig. 3(a). One observe a very good agreement with respect to the overall trend, the slope magnitude, and the location of the slope maximum. Generally, the magnetometer may therefore be operated at a specific combination of laser power input (P_in) of the laser irradiation, and a working frequency (f_c*) of the coupling structure, where a magnetic field sensitivity is maximized.

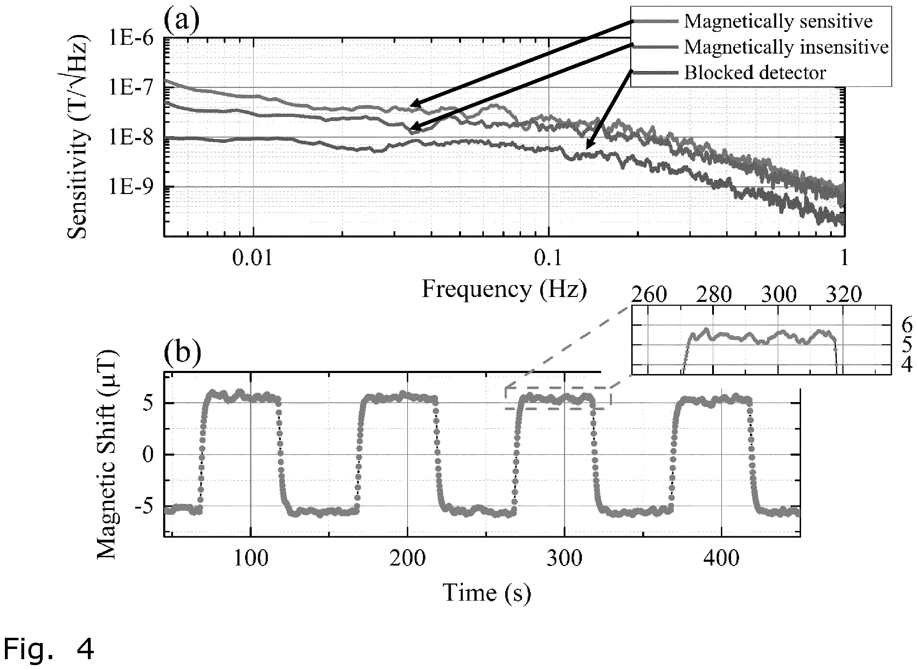

Figure 4 shows a) measurement of the magnetic noise spectral density in an embodiment of the present invention, and b) response of such a magnetometer of 10 mHz applied square-wave magnetic field.

For deducing the sensitivity of the magnetometer, there was independently measured three time traces of the locking signal for $P_{in} = 0.4$ W. The first trace was measured in the optimal magnetically sensitive configuration with the MW drive on resonance with a spin transition($\Delta = 0$) corresponding to the black dot in Fig. 2(b). The second trace was measured in the magnetically insensitive configuration, with the MW drive frequency far-detuned from any spin resonance ($\Delta\rightarrow\infty$). The last trace was measured with a blocked detector, which shows the sum of electronic noise from the lock-in detector and the photodetector 40.

The Fourier transforms of these time traces with a frequency resolution of 0.8 mHz are presented in Fig. 4(a) where the $\gamma$-axis is displayed in units of sensitivity. It shows a 0.125 mHz bandwidth and a 12 dB roll-off that is generated by the low-pass filter of the lock-in detector. The choice of this bandwidth is a consequence of the reduced ADMR contrast ($C_{ADMR}$ around $10^{-6}$) measured through the cavity transmission. When the MW drive is off resonance, a noise floor of approximately 30 nT/√Hz is achieved at a frequency of 10 mHz. The magnetically sensitive noise floor is higher than the magnetically insensitive noise floor due to low frequency magnetic noise sources such as temperature and magnetic background field fluctuations. For instance, the axial zero-field splitting is temperature-dependent and varies with -74.2 kHz/K.

Next, there was generated a 10 mHz square-wave magnetic field by placing a coil close to the diamond and monitored the magnetometer response by recording the lock-in signal. The result of this measurement is presented in Fig. 4(b). The standard deviation of 180 data points recorded within a 45 second duration is 167 nT. This exceeds the magnetically sensitive noise floor in Fig. 4(a) which can be attributed mainly to the noise generated by the current fluctuations in the coil. The zoomed inset shows part of the time trace with a standard deviation of 167 nT for 45 seconds duration.

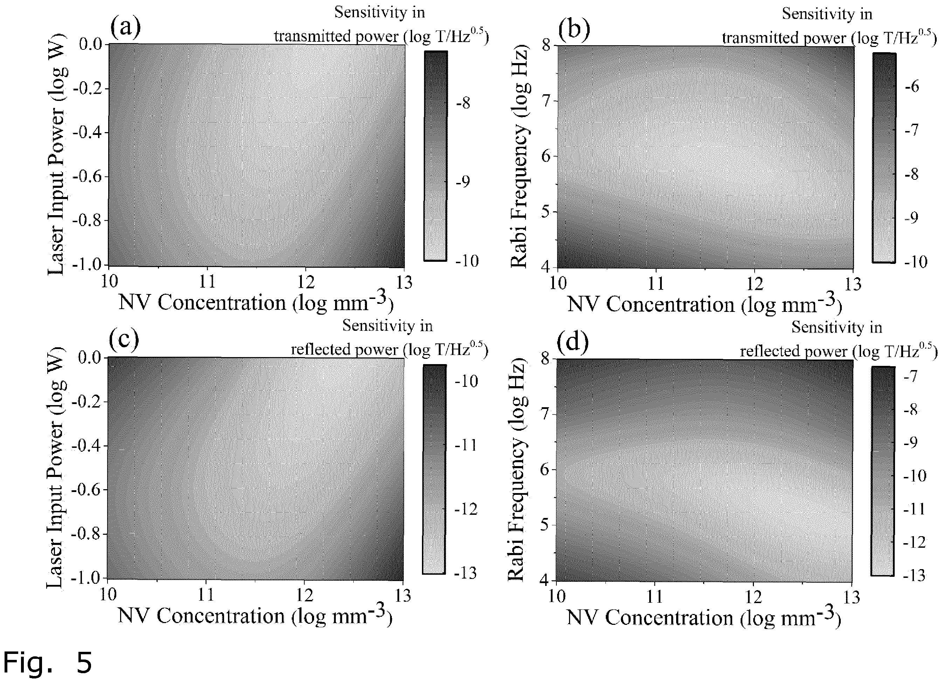

Figure 5 shows simulated plots of the shot-noise-limited sensitivity in embodiment of a magnetometer using ADMR according to the present invention.

To better understand the context and magnitude of the measured sensitivity, an estimate of the shot-noise-limited sensitivity for a single-peak ADMR as a function of [NV⁻], $P_{in}$, and $\Omega$ was made. Using the same physical dimensions in our setup (cavity length and diamond thickness), one assumes a diamond sample 10 where $\alpha^0_{abs} = \alpha^{NV}_{abs}$ for any [NV⁻]. In addition, one may consider that the reflectivity of the incoupling mirror is such that $R1 = R2e^{-\alpha}$ when $\Omega = 0$, ensuring that the cavity is impedance-matched, in comparison with our slightly under-coupled cavity. The intra-cavity power is thereby always maximized and there is no cavity reflection when no MW field is applied.

The shot-noise limited sensitivity was estimated from the ratio of the shot-noise level to max[d/dwS]. The results of this calculation are presented in Fig. 5 for both transmitted (a,b) and reflected (c,d) powers with fixed $\Omega = 0.5$ MHz for (a,c) and $P_{in} = 0.5$ W for (b,d). By monitoring the transmitted power Pt and optimizing [NV⁻], $P_{in}$, and $\Omega$, a remarkable shot-noise-limited sensitivity in the sub-nT/√Hz range can be expected. In comparison, by monitoring the reflected power $P_r$ a sensitivity in the sub-pT/√Hz range is projected. As the cavity is impedance-matched, applying no MW field results in $P_r(\Omega = 0) = 0$. However, applying $\Omega$ on resonance with a spin transition reduces the loss in the cavity and pushes the cavity into the over-coupled regime. Hence, the total reflected power of such an over-coupled cavity contributes to the ADMR signal, corresponding to a contrast of 100%.

In conclusion, the present invention relates to magnetic field sensing using an ensemble of NV centers based on the variation of a cavity's transmitted pump power due to electron-spin absorption. Frequency-modulated ADMR spectra were measured, which was used to measure the local magnetic noise spectral density with a noise floor of 30 nT/√Hz.

Simulations show that a photon shot-noise-limited sensitivity of sub-pT/√Hz can be achieved when measuring a cavity's reflected power near the impedance-matched point and using a diamond sample with an optimized NV density. Cavity-based ADMR is an exciting and advantageous alternative to its free-space ODMR counterpart, in terms of both detection contrast and device application. It is anticipated that the invention will provide a solid foundation for miniaturized NV-based magnetometers.

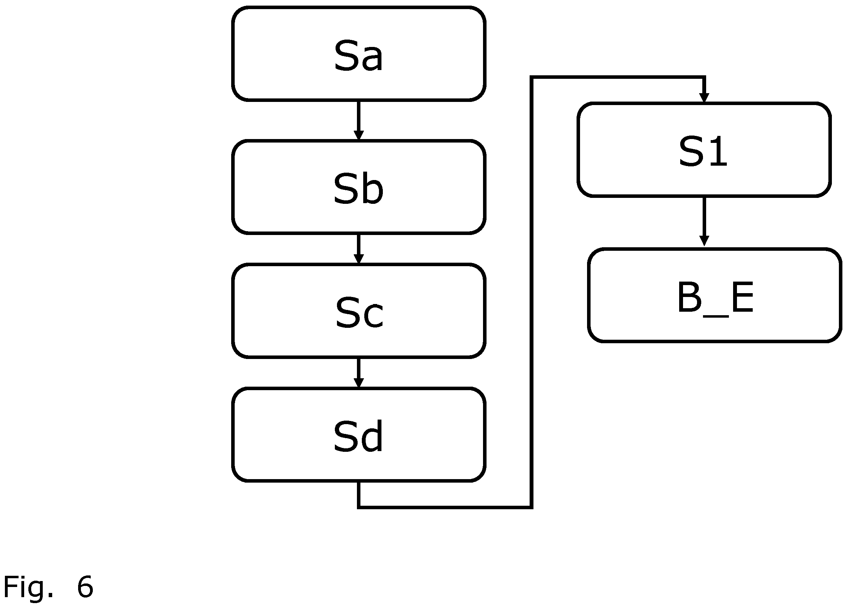

Figure 6 is a schematic system-chart representing an out-line of a method according to the invention. Thus, the method for measuring an external magnetic field **B_E** using absorption detected magnetic resonance (ADMR), the method comprises:

**Sa** providing a solid state material 10, such as diamond, comprising an ensemble of paramagnetic defects, the paramagnetic defects being optically active,

**Sb** providing an optical cavity 20 surrounding the solid state material, the optical cavity being optically excitable $\Gamma_P$ by laser irradiation from a laser 25 arranged therefore, cf. Figure 1B,

**Sc** providing a coupling structure 30 being arranged for electromagnetic coupling to said solid state material 10, the coupling structure being arranged for substantially homogenous radio frequency and/or microwave excitation $\Omega$ of the paramagnetic defects in the ground state |1>,|2>,

**Sd** providing a first optical detector 40 arranged for detecting laser irradiation traversing the optical cavity 20 and not being absorbed in the solid state material, cf. again Figure 1B,

**S1** wherein the laser irradiation is optically exciting ($\Gamma_P$) the ground state |1>,|2> to an excited state |3>,|4> in the solid state material 10, e.g. diamond cf. energy diagram in Figure 1A, and subsequently applying a measure S, e.g. $S^{Pt}_{LI}$ as explained above, indicative of the thereby absorbed laser irradiation obtained from the said first optical detector 40 to measure the external magnetic field **B_E**, preferably by a dedicated processor 50 arranged therefore.

Summarizing, the present invention relates to a magnetometer 100 for measuring an external magnetic field B_E using absorption detected magnetic resonance (ADMR) in a solid state material 10, such as diamond, cf. Figure 1B, with an ensemble of paramagnetic defects, being optically active. In an optical cavity 20 surrounding the solid state material, a coupling structure 30 is performing radio frequency and/or microwave excitation ($\Omega$) of the paramagnetic defects in the ground state |1>,|2>. A first optical detector 40 detects laser irradiation traversing the optical cavity 20 and not being absorbed in the solid state material. The laser irradiation is optically arranged for exciting ($\Gamma_P$) the ground state |1>,|2> to an excited state |3>,|4> in the solid state material 10, and the magnetometer subsequently applies a measure (S) indicative of the thereby absorbed laser irradiation obtained from the first optical detector 40 to measure the external magnetic field B_E. The invention is advantageous for both miniaturization and having improved sensitivity down to pico-Tesla/(Hz)^½.

The invention can be implemented by means of hardware, software, firmware or any combination of these. The invention or some of the features thereof can also be implemented as software running on one or more data processors and/or digital signal processors.

The individual elements of an embodiment of the invention may be physically, functionally and logically implemented in any suitable way such as in a single unit, in a plurality of units or as part of separate functional units. The invention may be implemented in a single unit, or be both physically and functionally distributed between different units and processors.

Although the present invention has been described in connection with the specified embodiments, it should not be construed as being in any way limited to the presented examples. The scope of the present invention is to be interpreted in the light of the accompanying claim set. In the context of the claims, the terms "comprising" or "comprises" do not exclude other possible elements or steps. Also, the mentioning of references such as "a" or "an" etc. should not be construed as excluding a plurality. The use of reference signs in the claims with respect to elements indicated in the figures shall also not be construed as limiting the scope of the invention. Furthermore, individual features mentioned in different claims, may possibly be advantageously combined, and the mentioning of these features in different claims does not exclude that a combination of features is not possible and advantageous.

**Claims**

1. A magnetometer (100) for measuring an unknown external magnetic field (B_E) using absorption detected magnetic resonance (ADMR), comprising:

    a) a solid state material (10) comprising an ensemble of paramagnetic defects, the paramagnetic defects being optically active,
    b) an optical cavity (20) surrounding the solid state material, the optical cavity being optically excitable ($\Gamma_P$) by laser irradiation from a laser (25) arranged therefore,
    c) a coupling structure (30) being arranged for electromagnetic coupling to said solid state material (10), the coupling structure being arranged for substantially homogenous radio frequency and/or microwave excitation ($\Omega$) of the paramagnetic defects in the ground state (|1>,|2>), and
    d) a first optical detector (40) arranged for detecting laser irradiation traversing the optical cavity (20) and not being absorbed in the solid state material,
    wherein the laser irradiation is optically arranged for exciting ($\Gamma_P$) the ground state (|1>,|2>) to an excited state (|3>,|4>) in the solid state material (10), and the magnetometer subsequently applies a measure (S) indicative of the thereby absorbed laser irradiation obtained from the said first optical detector (40) to measure the external magnetic field (B_E).

2. The magnetometer according to claim 1, wherein the first optical detector (40) is positioned so as to detect laser irradiation being reflected from the same side of optical cavity (20) as the laser irradiation enters the optical cavity.

3. The magnetometer according to claim 1 or 2, wherein the optical cavity (20) surrounding the solid state material comprises two mirrors (21, 22), and wherein a second optical detector (45) is optically connected to the optical cavity and arranged for providing a signal output to a feedback mechanism for adjusting the said optical cavity (20) and/or the irradiation laser (25), preferably by actuating one, or more, of the two mirrors, and/or by changing one or more optical properties of one, or more, of the two mirrors.

4. The magnetometer according to claim 1, 2 or 3, wherein the optical cavity (20) surrounding the solid state material comprises two mirrors (21, 22), and wherein the two mirrors in combination defines an optical path for said laser irradiation traversing the optical cavity through said solid state material, said optical path having a substantially straight Gaussian beam shape within the solid state material.

5. The magnetometer according to claim 1, wherein the irradiation laser (25) is configured to be substantially resonant with the optical cavity (20).

6. The magnetometer according to claim 1, wherein the optical cavity (20) is substantially impedance matched.

7. The magnetometer according to claim 6, wherein said impedance matching is performed by levelling an incoupling mirror (21) as being substantially equal to the cumulative round trip loss product in the cavity, preferably by configuring the magnetometer according to the approximate relation

$$P_{cav} = P_{laser}\, T_1\, /(1- \rho)^2,$$

where $T_1$ is the transmission of an incoupling mirror, $\rho$ is the cumulative round trip loss product in the cavity, $P_{laser}$ is the power of the irradiation laser, and $P_{cav}$ is the intra-cavity power.

8. The magnetometer according to claim 1, wherein the coupling structure (30) is operated at a working frequency (f_c*) where the absolute value of a derivative, with respect to the working frequency, of said measure (S) indicative of the absorbed laser irradiation is maximized.

9. The magnetometer according to claim 8, wherein magnetometer is further operated at a specific combination of laser power input (P_in) of the laser irradiation, and a working frequency (f_c*) of the coupling structure, where a magnetic field sensitivity is optimized.

10. The magnetometer according to claim 1, wherein optical measures are applied to remove or reduce high-order modes from said laser irradiation before entering the optical cavity so as to reduce a signal to noise ratio (S/N) in said measure (S) indicative of the absorbed laser irradiation.

11. The magnetometer according to claim 1, wherein the magnetometer is capable of measuring the said external magnetic field (B_E) using only a single excitation energy ($\Gamma_P$), preferably emitted by a single irradiation laser (25).

12. The magnetometer according to claim 1, wherein said solid state material (10) is a single crystal diamond, and the paramagnetic defects are nitrogen vacancy centers (NV), preferably with impurities levels of NV being maximum 10 ppm, preferably maximum 1 ppm, more preferably maximum 0.5 ppm.

13. The magnetometer according to claim 1, wherein the magnetometer - when measuring an external magnetic field (B_E) - is arranged for having a sensitivity of maximum 300 pT/(Hz)^½, preferably a sensitivity of maximum 100 pT/(Hz)^½, more preferably a sensitivity of maximum 50 pT/(Hz)^½, or even more preferably a sensitivity of maximum 1 pT/(Hz)^½.

14. A method for measuring an external magnetic field (B_E) using absorption detected magnetic resonance (ADMR), the method comprising:

- providing a solid state material (10) comprising an ensemble of paramagnetic defects, the paramagnetic defects being optically active,
- providing an optical cavity (20) surrounding the solid state material, the optical cavity being optically excitable ($\Gamma_P$) by laser irradiation from a laser (25) arranged therefore,
- providing a coupling structure (30) being arranged for electromagnetic coupling to said solid state material (10), the coupling structure being arranged for substantially homogenous radio frequency and/or microwave excitation ($\Omega$) of the paramagnetic defects in the ground state (|1>,|2>), and
- providing a first optical detector (40) arranged for detecting laser irradiation traversing the optical cavity (20) and not being absorbed in the solid state material,
wherein the laser irradiation is optically exciting ($\Gamma_P$) the ground state (|1>,|2>) to an excited state (|3>,|4>) in the solid state material (10), and subsequently applying a measure (S) indicative of the thereby absorbed laser irradiation obtained from the said first optical detector (40) to measure the external magnetic field (B_E).

Fig. 1A

Fig. 1B

Fig. 2

(a)

(b)

(c)

Fig. 3

EP 3 480 614 A1

Fig. 4

EP 3 480 614 A1

Fig. 5

Fig. 6

Europäisches
Patentamt

European
Patent Office

Office européen
des brevets

# EUROPEAN SEARCH REPORT

Application Number

EP 17 19 9705

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | AHMADI SEPEHR ET AL: "Nitrogen-vacancy ensemble magnetometry based on pump absorption", 2017 CONFERENCE ON LASERS AND ELECTRO-OPTICS (CLEO), THE OPTICAL SOCIETY, 14 May 2017 (2017-05-14), pages 1-2, XP033238160, [retrieved on 2017-10-25] * the whole document * | 1-14 | INV. G01R33/24 G01R33/32 G01N24/00 |
| Y,D | JENSEN K ET AL: "Cavity-enhanced room-temperature magnetometry using absorption by nitrogen-vacancy centers in diamond", ARXIV.ORG, CORNELL UNIVERSITY LIBRARY, 201 OLIN LIBRARY CORNELL UNIVERSITY ITHACA, NY 14853, 10 January 2014 (2014-01-10), XP080001403, DOI: 10.1103/PHYSREVLETT.112.160802 * the whole document * | 1-14 | |
| Y | SEPEHR AHMADI ET AL: "Pump-Enhanced Continuous-Wave Magnetometry Using Nitrogen-Vacancy Ensembles", PHYSICAL REVIEW APPLIED, vol. 8, no. 3, 5 September 2017 (2017-09-05), XP055431996, DOI: 10.1103/PhysRevApplied.8.034001 * figure 1(b) * | 3 | TECHNICAL FIELDS SEARCHED (IPC) G01R G01N |

-/--

The present search report has been drawn up for all claims

| Place of search | Date of completion of the search | Examiner |
|---|---|---|
| Munich | 12 April 2018 | Skalla, Jörg |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

page 1 of 2

## EUROPEAN SEARCH REPORT

Application Number

EP 17 19 9705

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | GEORGIOS CHATZIDROSOS ET AL: "Miniature cavity-enhanced diamond magnetometer", ARXIV.ORG, CORNELL UNIVERSITY LIBRARY, 201 OLIN LIBRARY CORNELL UNIVERSITY ITHACA, NY 14853, 7 June 2017 (2017-06-07), XP080768164, * section "Experiment" * ----- | 1-14 | |
| T | SEPEHR AHMADI ET AL: "Nitrogen-vacancy ensemble magnetometry based on pump absorption", PHYSICAL REVIEW B, vol. 97, no. 2, 11 January 2018 (2018-01-11), XP055466414, ISSN: 2469-9950, DOI: 10.1103/PhysRevB.97.024105 * the whole document * ----- | | |

TECHNICAL FIELDS SEARCHED (IPC)

The present search report has been drawn up for all claims

| Place of search | Date of completion of the search | Examiner |
|---|---|---|
| Munich | 12 April 2018 | Skalla, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 2 of 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2016126436 A
- WO 2012174019 A

**Non-patent literature cited in the description**

- **K. JENSEN et al.** *Physical Review Letters,* 2014, vol. 112, 160802